# EUROPÄISCHE PATENTSCHRIFT

(11) **EP 1 133 413 B1**
(45) Veröffentlichungstag und Bekanntmachung des Hinweises auf die Patenterteilung: **08.10.2003**
(21) Anmeldenummer: 99964382.8
(22) Anmeldetag: 25.11.1999
(51) Int. Cl.: B60R 21/00, H05K 5/00, B60R 16/02

(54) **STEUERGERÄT FÜR DEN INSASSENSCHUTZ IN EINEM FAHRZEUG SOWIE VERFAHREN ZUM HERSTELLEN EINES STEUERGERÄTS**
CONTROL DEVICE FOR PROVIDING PASSENGER PROTECTION IN A VEHICLE AND METHOD FOR PRODUCING A CONTROL DEVICE OF THIS TYPE
APPAREIL DE COMMANDE DESTINE A LA PROTECTION D'UN PASSAGER D'UN VEHICULE ET SON PROCEDE DE PRODUCTION

(30) Priorität: 25.11.1998 DE 19854449
(43) Veröffentlichungstag der Anmeldung: 19.09.2001
(73) Patentinhaber: SIEMENS AKTIENGESELLSCHAFT, 80333 München (DE); Bayer Aktiengesellschaft, 51368 Leverkusen (DE)
(72) Erfinder: BAUER, Hans-Peter, D-93049 Regensburg (DE); DIRMEYER, Josef, D-92439 Bodenwöhr (DE); KRAUSE, Volkhard, D-51373 Leverkusen (DE)
(74) Vertreter: Berg, Peter, Dipl.-Ing.
(86) Internationale Anmeldenummer: DE9903743
(87) Internationale Veröffentlichungsnummer: WO00030899

(56) Entgegenhaltungen:
- DE-A- 4 300 342
- DE-A- 19 512 255

## Beschreibung

Die Erfindung betrifft ein Steuergerät für den Insassenschutz in einem Fahrzeug gemäß Oberbegriff des Patentanspruchs 1 sowie ein Verfahren zum Herstellen eines Steuergeräts.

Bekannte Steuergeräte für den Insassenschutz enthalten gewöhnlich ein Gehäuse aus Metall und insbesondere aus Aluminiumdruckguß. Das Gehäuse enthält Befestigungslaschen zum Verschrauben des Gehäuses am Fahrzeug. Das Gehäuse beherbergt einen Schaltungsträger, auf dem ein Aufprallsensor, z.B. ein Beschleunigungssensor oder ein Körperschallsensor angeordnet ist. Der Schaltungsträger ist am Gehäuse befestigt. Über die Befestigungslaschen und das Metallgehäuse wird bei einem Aufprall eine gute Signalübertragung vom Fahrzeug auf den Sensor gewährleistet.

Das bekannte Gehäuse ist schwer und in seiner Herstellung aufwendig und teuer. Ferner müssen Gehäusebestandteile dicht miteinander verbunden werden, um das Eindringen von Feuchtigkeit oder Gasen in das Gehäuseinnere zu verhindern. Dazu werden gewöhnlich aufwendig zu handhabende Dichtelemente wie Gummis etc. verwendet.

Aus anderen Technologiesparten wie der Kommunikationstechnik sind Gehäuse bekannt, die vollständig aus Kunststoff hergestellt sind. Ein solches Gehäuse kann jedoch keine ausreichende Signalübertragung vom Fahrzeug zum Aufprallsensor gewährleisten, da die meisten Kunststoffe niederfrequente Schwingungen dämpfen und der Aufprallsensor somit ein unvollständiges, für die Beurteilung eines Aufpralls nicht ausreichendes Signal empfängt.

Ein solches Kunststoffgehäuse ist auch aus der gattungs bildenden DE 43 00 342 A1 zur Verwendung für ein Steuergerät für einen Airbag eines Kraftfahrzeugs bekannt. Das dortige Kunststoffgehäuse ist als dreidimensionale Leiterplatte ausgebildet, deren Außenseite metallisiert ist und eine HF-Abschirmung bildet und deren Innenseite mit Leiterbahnen versehen ist. Die Steifigkeit dieses bekannten Gehäuses und somit die mechanische Kopplung zu einer Fahrzeugkarosserie läßt jedoch zu wünschen übrig.

Aufgabe der Erfindung ist es deshalb, ein Steuergerät für den Insassenschutz bereitzustellen, das auf einfache Art hergestellt und abgedichtet werden kann, und das gleichzeitig eine gute Signalübertragung zum im Gehäuse angeordneten Aufprallsensor gewährleistet.

Der das Steuergerät betreffende Teil der Erfindungsaufgabe wird durch die Merkmale der Patentanspruche 1, 2 und 8 gelöst.

Dabei wird der Aufprallsensor in einem im wesentlichen aus Kunststoff bestehenden Gehäuse angeordnet. So sind die Gehäusewandungen, der Gehäuseboden und vorzugsweise auch der Gehäusedeckel und ein Steckerteil aus Kunststoff hergestellt. Zur Gewährleistung einer ausreichenden Signalübertragung weist das Gehäuse jedoch einen steifen oder versteiften Rahmen auf. Das Gehäuse wird über zumindest ein am Rahmen angeordnetes und vorzugsweise mit diesem einstückig ausgebildetes Befestigungselement am Fahrzeug befestigt. Der Sensor wiederum ist mechanisch mit dem Rahmen gekoppelt. Diese mechanische Kopplung äußert sich in einer vorzugsweisen Anordnung des Sensors am Rahmen selbst oder in einer vorzugsweisen Anordnung des Sensors auf einem Schaltungsträger, welche seinerseits am Rahmen befestigt ist. Eine solche mechanische Kopplung dient zum Übertragen von durch einen Aufprall hervorgerufenen Fahrzeugschwingungen/Fahrzeugbeschleunigungen direkt über den Rahmen auf den Sensor, gegebenenfalls unter Zwischenschaltung des Schaltungsträgers, wobei jedoch der aus dem signaldämpfenden Kunststoff hergestellte Teil des Gehäuses kein Bestandteil des Signalpfades zum Sensor ist. Der Rahmen ist derart steif ausgebildet, daß er Signale weitgehend dämfungsfrei auch im niederen Frequenzbereich übertragen kann. Ferner sollte der Rahmen möglichst geringe Schwingungsneigung aufweisen und damit möglichst zug- und biegefest wie auch torsionssteif ausgebildet sein. Die Festigkeit des Rahmens und insbesondere seine Biegesteifigkeit entspricht etwa oder übersteigt sogar die Festigkeitswerte geschlossener, als Gehäuse verwendeter Stahlstrukturen. Daher ist der Rahmen nicht aus dem gleichen Kunststoff wie das übrige Gehäuse hergestellt, der diesen Anforderungen gewöhnlich nicht genügt.

Vielmehr ist der Rahmen in vorzugsweisen Weiterbildungen der Erfindung entweder als Vollmetallrahmen und insbesondere als Aluminiumdruckguß ausgebildet, oder als Kunststoffrahmen unter Verwendung eines hochfesten Kunststoffes, z.B. eines LCP-Kunststoffes, der den genannten Erfordernissen genügt.

Der das Verfahren betreffende Teil der Erfindungsaufgabe wird durch die Merkmale des Patentanspruchs 9 gelöst.

Vorteilhafte Weiterbildungen der Erfindung sind durch die Unteransprüche gekennzeichnet.

Die Zeichnung zeigt ein Ausführungsbeispiel der Erfindung. Es zeigen im einzelnen:
Figur 1: einen Schaltungsträger mit einem Aufprallsensor,
Figur 2: Metallstege eines Gehäuserahmens, und
Figur 3: ein erfindungsgemäßes Steuergerät.

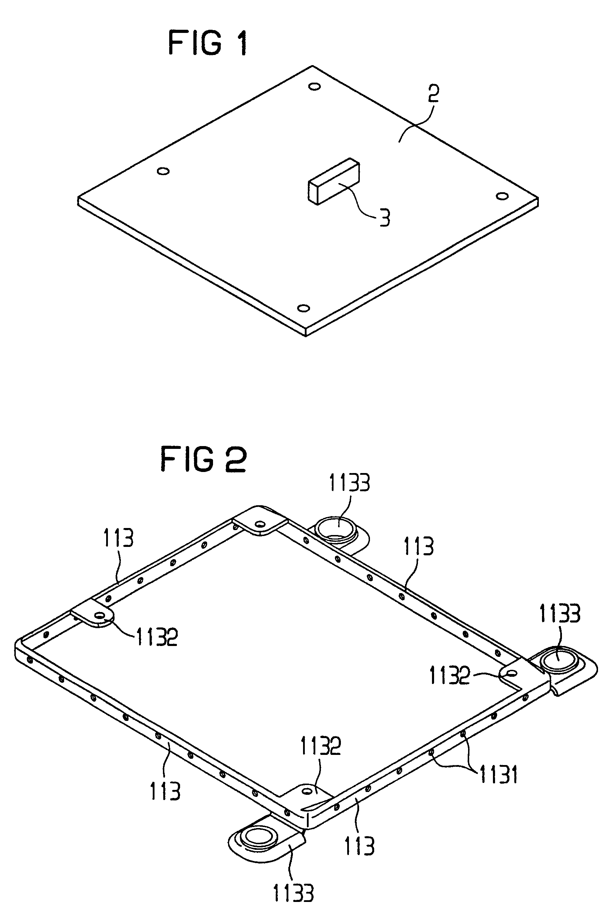

Figur 2 zeigt das Gerippe eines eines erfindungsgemäßen Gehäuserahmens, mit Metallstegen 113, Schaltungsträgerbefestigungen 1132, Metallösen 1133, und Bohrungen 1131 in den Metallstegen 113. Die Metallstege 113 mit den einstückig angeformten Schaltungsträgerbefestigungen 1132 und Metallösen 1133 werden vorzugsweise durch einen Tiefziehvorgang oder durch einen Stanzvorgang aus einem Stahlblech gewonnen. In einem weiteren Herstellungsschritt werden die Metallstege 113 durch Bohren, Stanzen, Drücken oder Lochen mit den Bohrungen 1131 versehen, wie auch die Schaltungsträgerbefestigungen 1132 und die Metallösen 1133 mit Bohrungen versehen werden. In einem weiteren Schritt werden die Schaltungsträgerbefestigungen 1132 und die Metallösen 1133 umgebogen.

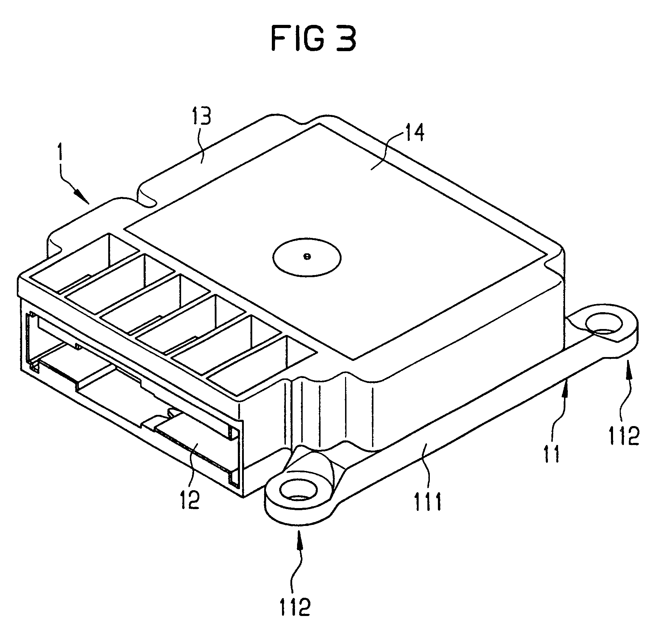

Das derart hergestellte Gerippe des Gehäuserahmens nach Figur 2 wird daraufhin in ein Spritzwerkzeug eingelegt und mit Kunststoff umspritzt. Der verwendete Kunststoff ist vorzugsweise ein elastomermodifiziertes oder glasfaserverstärktes Polyamid PA 6 GF 30, vorzugsweise vom Typ Durethan ® BKV 130, der Firma Bayer AG oder ein PBT-Polybutylenterephtalat. Beim Spritzvorgang dringt die Kunststoffschmelze durch die Bohrungen 1131 der Metallstege 113. In jeder Bohrung 1131 entsteht damit ein Kunststoffnietkopf. Derart angespritzte Kunststoffversteifungen 111 des Rahmens 11 sind in Figur 3 ersichtlich. Es entsteht eine hochbelastbare kraft- und formschlüssige Verbindung zwischen den Metallstegen 113 und den Kunststoffversteifungen 111. Zur Verbindung zwischen Metall und Kunststoff ist weder ein Haftmittler noch eine andere Komponente erforderlich. Infolge der Unterstützung durch die Kunststoffversteifungen können die Metallstege 113 relativ dünnwandig ausgebildet sein, ohne daß der gesamte Rahmen 11 an Stabilität und Belastbarkeit verliert. Überdies verringert sich das Gewicht des Gehäuses durch die Verwendung der Kunststoffversteifungen 111.

Der in Figur 1 symbolisch angedeutete Schaltungsträger 2 mit dem darauf aufgebrachten Aufprallsensor 3 wird vor oder nach dem Anspritzen der Kunststoffversteifungen 111 an die Metallstege 113 an den Schaltungsträgerbefestigungen 1132 befestigt, vorzugsweise durch Anschrauben. Nachfolgend wird das übrige Kunststoffgehäuse 1 an den Rahmen 11 angespritzt. In Figur 3 ist ein fertiges Steuergerät mit dem Gehäuse 1 zu sehen. Dabei enthält das Kunststoffgehäuse 1 neben dem Rahmen 11 mit den Metallstegen 131 einstückig ausgebildete Wandungen 13, einen Gehäuseboden 14 und ein Steckerteil 12. Die nicht sichtbare Unterseite des Steuergerätes ist ebenfalls mit einer angespritzten Kunststoffwandung versehen. Alternativ kann dieser Kunststoffdeckel auch in lösbarer Art am Gehäuse 1 befestigt sein.

Der Rahmen 11 enthält mit Kunststoff umspritzte Befestigungselemente 112, deren metallenes Gerüst die Metallösen 1133 bilden. Nach Fertigstellung des Steuergeräts wird selbiges mit durch die Befestigungslemente 112 geführte Schrauben an der Fahrzeugkarosserie befestigt.

Das erfindungsgemäße Steuergerät kann auf einfache Art dicht gehalten werden, da abzudichtende Stellen nur zwischen Kunststoffteilen entstehen. Diese Kunststoffteile können auf einfache Art und Weise zu einer dichten, unlösbaren Verbindung verschmolzen werden. Selbst unter Maßgabe einer lösbaren Verbindung zwischen diesen Kunststoffteilen kann durch Anspritzen einer weichen, elastischen Kunststoffdichtung auf einfache Art und Weise eine zuverlässig wirkende Dichtung entstehen. Ferner erübrigt sich eine Abdichtung des Steckerteils.

Die Erfindung liefert ein einfach herzustellendes, leichtes Steuergerät, das dennoch eine gute Signalübertragung zum Aufprallsensor bereitstellt.

## Patentansprüche

1. Steuergerät für den Insassenschutz in einem Fahrzeug,
- mit einem Sensor (3) zum Erkennen eines Aufpralls,
- mit einem aus Kunststoff hergestellten Gehäuse (1), das den Sensor (3) enthält, und
- mit einem Befestigungselement (112) zum Befestigen des Steuergeräts am Fahrzeug
**dadurch gekennzeichnet,**
- **daß** das Gehäuse (1) einen steifen aus Metall hergestellten Rahmen (11) enthält,
- daß das Befestigungselement (112) am Rahmen (11) angeordnet ist, und
- **daß** der Sensor (3) mechanisch derart mit dem Rahmen gekoppelt ist, daß der aus Kunststoff hergestellte Teil des Gehäuses (1) Kein ßestandteil des Signelpfades zum Sensor (3) ist.

2. Steuergerät für den Insassenschutz in einem Fahrzeug,
- mit einem Sensor (3) zum Erkennen eines Aufpralls,
- mit einem aus Kunststoff hergestellten Gehäuse (1), das den Sensor (3) enthält, und
- mit einem Befestigungselement (112) zum Befestigen des Steuergeräts am Fahrzeug
**dadurch gekennzeichnet,**
- **daß** das Gehäuse (1) einen steifen, aus einem gegenüber dem übrigen Gehäuse (1) härteren Kunststoff hergestellten Rahmen (11) enthält,
- daß das Befestigungselement (112) am Rahmen (11) angeordnet ist, und
- **daß** der Sensor (3) mechanisch derart mit dem Rahmen gekoppelt ist, daß der aus dem weicheren kunststoff her gestellte Teil des Gehäuses (1) Kein Bestandteil des Signalpfades zum Sensor(3) ist.

3. Steuergerät nach Anspruch 1 oder 2, **dadurch gekennzeichnet, daß** der Sensor (3) auf einem Schaltungsträger (2) angeordnet ist, und daß der Schaltungsträger (2) an dem Rahmen (11) befestigt ist.

4. Steuergerät nach Anspruch 3 und Anspruch 4, **dadurch gekennzeichnet, daß** ein Potential des Schaltungsträgers (2) elektrisch mit dem Rahmen (11) verbunden ist.

5. Steuergerät nach einem der vorhergehenden Ansprüche, **dadurch gekennzeichnet, daß** das Gehäuse (1) ein einstückig angeformtes Steckerteil (12) enthält.

6. Steuergerät nach einem der Ansprüche 1 und 3 bis 5, **dadurch gekennzeichnet, daß** der Rahmen (11) Metallstege (113) enthält.

7. Steuergerät nach Anspruch 6, **dadurch gekennzeichnet, daß** die Metallstege (113) eine Vielzahl von Bohrungen (1131) aufweisen, und daß Kunststoff-Versteifungen (111) an die Metallstege (113) angespritzt sind.

8. Verfahren zum Herstellen eines Steuergeräts für den Insassenschutz in einem Fahrzeug,
- bei dem ein Rahmen (11) mit Metallstegen (113) hergestellt wird,
- bei dem die Metallstege (113) mit Bohrungen (1131) versehen werden,
- bei dem Kunststoff-Versteifungen (111) an die Metallstege (113) gespritzt werden,
- bei dem ein Sensor (3) zum Erkennen eines Aufpralls derart mechanisch mit dem Rahmen (11) gekoppelt wird, daß der aus Kunststoff hergestellte Teil eines Gehäuses (1) Kein Bestandteil des Signalpfades zum Sensor (3) ist und
- bei dem das Gehäuse (1) aus Kunststoff an den Rahmen (11) angespritzt wird.

9. Verfahren nach Anspruch 8, bei dem die Metallstege (113) durch einen Metall-Tiefziehprozeß gewonnen werden.

## Claims

1. Control unit for protecting the passengers in a motor vehicle,
- with a sensor (3) to detect a crash,
- with a housing made of plastic (1) that contains the sensor (3), and
- with an attachment element (112) to attach the control unit to the vehicle
**characterized in that**
- the housing (1) contains a rigid frame made of metal (11)
- that is the attachment element (112) is located on the frame (11) and
- that the sensor (3) is mechanically coupled to the frame in such a way that the plastic part of the housing (1) is not a component of the signal path to the sensor (3).

2. Control unit for protecting the passengers in a motor vehicle,
- with a sensor (3) to detect a crash,
- with a housing made of plastic (1) that contains the sensor (3), and
- with an attachment element (112) to attach the control unit to the vehicle
**characterized in that**
- the housing (1) contains a rigid frame which is made of a plastic which is harder than the other housing(s)
that the sensor (3) is mechanically coupled to the frame in such a way that the part of the housing (1) made of softer plastic is not a component of the signal path to the sensor (3).

3. Control unit in accordance with Claim 1, **characterized in that** the sensor (3) is located on a circuit carrier (2) and that the circuit carrier (2) is attached to the frame (11).

4. Control unit in accordance with Claim 3 and Claim 4, **characterized in that** a potential of the circuit carrier (2) is electrically connected with the frame (11)

5. Control unit in accordance with one of the previous claims, **characterized in that** the housing (1) contains in a one-piece molded connector (12).

6. Control unit in accordance with one of the claims 1 and 3-5, **characterized in that** the frame (11) contains metal bars (113).

7. Control unit in accordance with Claims 7, **characterized in that** the metal bars (113) feature a large number of holes (1131) and that plastic reinforcements (111) are sprayed onto the metal bars.

8. Method of manufacturing a control unit for protecting the passengers in a motor vehicle,
- in which a frame of (11) is manufactured with metal bars (113)
- in which the metal bars (113) are equipped with holes (1131)
- in which the plastic reinforcements (111) are sprayed on to the metal bars (113)
- in which a sensor (3) to detect a crash is coupled mechanically to the frame (11) in such a way that the part of the housing (1) made of plastic is not an element of the signal path to the sensor (3) and
- in which the plastic housing (1) is sprayed on to the frame (11)

9. Method in accordance with Claim 8, in which the metal bars (113) are obtained by a deep extrusion metal process.

## Revendications

1. Appareil de commande pour la protection des passagers d'un véhicule
- avec un capteur (3) pour la détection d'un impact,
- avec un boîtier (1) réalisé en matière plastique comportant le capteur (3) et
- avec un élément de fixation (112) pour la fixation de l'appareil de commande sur le véhicule
**caractérisé en ce que**
- le boîtier (1) comporte un cadre rigide réalisé en métal (11),
- que l'élément de fixation (112) est disposé sur le cadre (11) et
- que le capteur (3) est couplé mécaniquement au cadre de sorte que la partie réalisée en matière plastique du boîtier (1) n'est pas un composant du parcours du signal vers le capteur (3).

2. Appareil de commande pour la protection des passagers d'un véhicule
- avec un capteur (3) pour la détection d'un impact,
- avec un boîtier (1) réalisé en matière plastique comportant le capteur (3) et
- avec un élément de fixation (112) pour la fixation de l'appareil de commande sur le véhicule
**caractérisé en ce que**
- le boîtier (1) comporte un cadre rigide (11) réalisé en une matière plastique plus dure comparée au reste du boîtier (1)
- que l'élément de fixation (112) est disposé sur le cadre (11) et
- que le capteur (3) est couplé mécaniquement au cadre de sorte que la partie réalisée en matière plastique moins dure du boîtier (1) n'est pas un composant du parcours du signal vers le capteur (3).

3. Appareil de commande selon une des revendications 1 ou 2, **caractérisé en ce que** le capteur (3) est disposé sur un support de montage (2) et que le support de montage (2) est fixé sur le cadre (11).

4. Appareil de commande selon les revendications 3 et 4, **caractérisé en ce qu'**un potentiel du support de montage (2) est électriquement relié au cadre (11).

5. Appareil de commande selon l'une des revendications précédentes, **caractérisé en ce que** le boîtier (1) comporte une partie connecteur (12) formant une pièce avec celui-ci.

6. Appareil de commande selon l'une des revendications 1 et 3 à 5, **caractérisé en ce que** le cadre (11) comporte des barrettes métalliques (113).

7. Appareil de commande selon la revendication 6, **caractérisé en ce que** les barrettes métalliques (113) présentent une pluralité de perçages (1131) et que des raidisseurs en matière plastique (111) sont réalisés par injection sur les barrettes métalliques (113).

8. Procédé de réalisation d'un appareil de commande pour la protection des passagers d'un véhicule
- dans lequel on réalise un cadre (11) avec des barrettes métalliques (113),
- dans lequel les barrettes métalliques (113) sont pourvues de perçages (1131),
- dans lequel des raidisseurs en matière plastique (111) sont réalisés par injection sur les barrettes métalliques (113),
- dans lequel un capteur (3) est couplé mécaniquement au cadre (11) pour la détection d'un impact de sorte que la partie réalisée en matière plastique d'un boîtier (1) n'est pas un composant du parcours du signal vers le capteur (3)
- dans lequel le boîtier (1) en matière plastique est réalisé par injection sur le cadre (11).

9. Procédé selon la revendication 8, dans lequel les barrettes métalliques (113) sont obtenues par un processus d'emboutissage de métal.
